**Europäisches Patentamt**

**European Patent Office**

**Office européen des brevets**

(19)

(11) Veröffentlichungsnummer: **0 208 943 B1**

# EUROPÄISCHE PATENTSCHRIFT

(12)

(45) Veröffentlichungstag der Patentschrift: **10.04.91**

(51) Int. Cl.⁵: **G03F 7/40**

(21) Anmeldenummer: **86108390.5**

(22) Anmeldetag: **19.06.86**

(54) Verfahren zur Herstellung von klebfreien, glatten Oberflächen von photopolymerisierten Reliefdruckformen für den Flexodruck.

(30) Priorität: **20.06.85 DE 3521955**

(43) Veröffentlichungstag der Anmeldung:
**21.01.87 Patentblatt 87/04**

(45) Bekanntmachung des Hinweises auf die
Patenterteilung:
**10.04.91 Patentblatt 91/15**

(84) Benannte Vertragsstaaten:
**BE CH DE FR GB IT LI NL SE**

(56) Entgegenhaltungen:
**EP-A- 0 115 414**
**DE-A- 2 753 128**
**US-A- 3 255 004**
**US-A- 4 400 460**

(73) Patentinhaber: **BASF Aktiengesellschaft**
**Carl-Bosch-Strasse 38**
**W-6700 Ludwigshafen(DE)**

(72) Erfinder: **Koch, Horst, Dr.**
**Schliffgasse 22**
**W-6711 Grosskarlbach(DE)**
Erfinder: **Jaeckel, Klaus-Peter, Dr.**
**Uhlandweg 13**
**W-7602 Oberkirch(DE)**

**Beschreibung**

Die Erfindung betrifft ein Verfahren zur Herstellung von klebfreien, glatten Oberflächen von photopolymerisierten Reliefdruckformen für den Flexodruck, die in der Reliefschicht mindestens ein Bindemittel auf der Basis elastomerer Dienpolymerisate aufweisen.

Photopolymerisierbare Druckplatten, die in der reliefbildenden Schicht mindestens ein elastomeres Dienpolymerisat als Bindemittel aufweisen, sowie die Herstellung von Reliefformen daraus sind allgemein bekannt. Als Bindemittel kommen dabei z.B. insbesondere thermoplastisch-elastomere Blockcopolymerisate aus Dien- und Vinylaromat-Monomeren oder elastomere Dien-Acrylnitril-Copolymerisate zur Anwendung. Wir verweisen hierzu beispielhaft auf die DE-AS 22 15 090 oder DE-OS 24 56 439. Die durch bildmäßiges Belichten, Auswaschen und Trocknen aus diesen photopolymerisierbaren Druckplatten hergestellten photopolymerisierten Reliefdruckformen haben den Nachteil, daß sie meist klebrige Oberflächen aufweisen, die beim Drucken zum Rupfen und zum Reißen von Papierbahnen führen. Außerdem werden durch herausgerupfte Papierfasern feine Bildelemente zugeschmiert. Häufig sind diese klebrigen Oberflächen auch nicht beständig gegenüber den Lösungsmitteln, in welchen die Druckfarben gelöst werden. Dies führt letztlich zu einer Zerstörung der photopolymerisierten Reliefdruckform beim Drucken. Zur Lösung dieses Problems sind bereits zahlreiche Vorschläge gemacht worden. Wir verweisen hierzu auf die Druckschriften

(1) DE-OS 28 23 300,
(2) EP-A 21 829,
(3) EP-A 64 564,
(4) EP-A 64 565 und
(5) EP-A 96 835.

Wir verweisen ferner auf die Firmenschrift "®Cyrel System", E.I. DuPont de Nemours und Co. Inc., Wilmington, Seite T-6, April 1975. In (1) wird die Nachbehandlung von photopolymerisierten Reliefdruckformen für den Flexodruck, die in ihrer Reliefschicht Styrol-Isopren-Blockcopolymerisate enthalten, mit Brom enthaltenden flüssigen Medien beschrieben. (2) beschreibt die Iodierung von Flexodruckplatten, welche natürliche und synthetische Dienpolymerisate enthalten, mit Jod in wäßriger Kaliumjodidlösung. (3) beansprucht die Bromierung von photopolymerisierten Reliefdruckformen, die kautschukelastische Bindemittel auf der Basis von Butadien-Acrylnitril-Copolymerisaten enthalten, mit wäßrigen 0,1 bis 3,5 gew.-%igen Bromlösungen. Die Dauer der Bromierung beträgt 15 Sekunden bis 20 Minuten. In (4) wird ausgeführt, daß man zur Nachbehandlung solcher Reliefdruckformen wäßrige Lösungen aus einem Alkalimonopersulfat und einem Bromsalz einsetzt. In (5) wird eine Nachbehandlung, die eine Bromierung oder eine Iodierung und eine sich daran anschließende Chlorierung der Oberfläche solcher photopolymerisierter Reliefdruckformen umfaßt, empfohlen. Schließlich wird in der obengenannten Firmenschrift die Nachbehandlung mit salzsauren Hypochlorit-Lösungen beschrieben. All diese genannten Verfahren senken die Klebrigkeit der Oberfläche der photopolymerisierten Reliefdruckformen und machen diese auch beständiger gegenüber Lösungsmittel für Druckfarben. Die Oberflächen werden jedoch nicht gleichmäßig gut von der Klebrigkeit befreit. Die visuelle Betrachtung solcher Oberflächen hinterläßt den Eindruck einer würmchenförmigen Struktur, deren Kontrast durch die obengenannte Nachbehandlung mit Brom oder Chlor noch verstärkt wird. Darüber hinaus bilden sich auf solchen Oberflächen beim Wegwaschen der Brom-, Iod- oder Chlorreste Tropfenspuren aus. Beim Drucken machen sich diese Oberflächenstrukturen im Druckergebnis unangenehm bemerkbar. Außerdem werden photopolymerisierte Reliefdruckformen, deren Oberflächen solche Strukturen aufweisen, bei höheren Druckauflagen wieder klebrig.

Es hat sich somit letztlich gezeigt, daß die Verfahren zur Nachbehandlung von photopolymerisierten Reliefdruckformen, die dem Stande der Technik entsprechen, zu unbefriedigenden Ergebnissen führen. Dies ist vor allem auf die speziellen Eigenschaften der eingesetzten Nachbehandlungsbäder zurückzuführen. Diese verteilen sich oftmals ungleichmäßig auf der zu behandelnden Oberfläche und führen so zu einer ungleichmäßigen Halogenierung. Desweiteren ist das Resultat der Nachbehandlung in hohem Maße abhängig von der Art und dem Zeitpunkt der Herstellung der üblicherweise eingesetzten Behandlungsbäder: Elementares Halogen enthaltende Lösungen sind meist recht instabil und besitzen nur eine geringe Standzeit. Versäumt man den richtigen Zeitpunkt ihrer Anwendung, erhält man in nichtvorhersagbarer Weise besonders schlechte Resultate. Dies macht eine exakte Koordination des Zeitpunktes der Herstellung der Bäder und der Durchführung der Nachbehandlung notwendig. Eine solche Koordination ist aber in der Paxis nicht immer gegeben. Zur Verbesserung der Benetzungseigenschaften salzsaurer Hypochlorit-Lösungen wird in der obengenannten Firmenschrift die Zugabe von Netzmitteln empfohlen. Dabei wird nicht angegeben, welcher Natur die Netzmittel sind. Diese Nachbehandlungslösungen müssen nach dem Mischen sofort verwendet werden, die Haltbarkeitsgrenze liegt bei nur 30 Minuten. Sie liefern auch keine glatten, strukturlosen Oberflächen bei Reliefdruckformen und beseitigen daher nicht die obengenannten Nachteile in vollem Umfange.

Der vorliegenden Erfindung lag daher die Aufgabe zugrunde, die Nachteile der bekannten Nachbehandlungsverfahren für photopolymerisierte Reliefdruckformen möglichst zu beseitigen und eine einfach durchzuführende Nachbehandlung von photopolymerisierten Reliefdruckformen für den Flexodruck aufzuzeigen, bei der Druckformen resultieren, welche gleichmäßig klebfrei sind, eine strukturlose, glatte Oberfläche aufweisen und auch nach höheren Druckauflagen beim Flexodruck nicht wieder klebrig werden. Der vorliegenden Erfindung lag ferner die Aufgabe zugrunde, Nachbehandlungsbäder mit langer Standzeit vorzuschlagen.

Es wurde nun überraschenderweise gefunden, daß die Aufgabe gelöst wird durch ein Verfahren zur Herstellung von klebfreien, glatten Oberflächen von photopolymerisierten Reliefdruckformen für den Flexodruck, deren Reliefschichten hergestellt wurden durch

A) bildmäßiges Belichten mit aktinischem Licht einer lichtempfindlichen photopolymerisierbaren und/oder photovernetzbaren, reliefbildenden Schicht, enthaltend

a) mindestens ein Bindemittel auf der Basis elastomerer Dienpolymerisate,
b) mindestens ein damit verträgliches, olefinisch ungesättigtes, photopolymerisierbares und/oder photovernetzbares Monomeres,
c) mindestens einen Photoinitiator,
d) gegebenenfalls enthaltend übliche Hilfs- und/oder Zusatzstoffe,

B) Auswaschen der nicht-photopolymerisierten und/oder nicht-vernetzten, unbelichteten Bereiche mit einem geeigneten flüssigen Medium,
C) gegebenenfalls sich daran anschließendes Trocknen und/oder
D) Nachbelichten mit aktinischem Licht der so gebildeten Reliefdruckform,

bei dem

E) die Oberfläche der photopolymerisierten Reliefdruckform mit einem mindestens ein Tensid sowie elementares Brom enthaltenden oder einem mindestens ein Tensid enthaltenden und zur Bildung von elementarem Brom befähigten flüssigen Medium nachbehandelt und anschließend
F) die Oberfläche der photopolymerisierten Reliefdruckform mit einem neutralisierend und/oder reduzierend wirkenden flüssigen Medium ausgewaschen wird und bei dem gegebenenfalls
G) die solchermaßen nachbehandelte photopolymerisierte Reliefdruckform getrocknet und/oder
H) mit aktinischem Licht nachbelichtet wird, sofern dies noch nicht im Verfahrensschritt D geschehen ist.

Das erfindungsgemäße Verfahren ist dadurch gekennzeichnet, daß die für den Verfahrensschritt E verwendeten flüssigen Medien mindestens ein Tensid aus der Gruppe gesättigtes Paraffinsulfonat mit einer Kohlenwasserstoffkette mit 8 bis 20 Kohlenstoffatomen, anionisches oder kationisches Tensid mit einer oder mehreren 5 bis 18 Kohlenstoffatome aufweisenden perfluorierten Kohlenstoffketten, Fettalkoholethersulfat oder Alkylphosphat enthalten.

Eine bevorzugte Ausführungsform der Erfindung besteht darin, daß das für den Verfahrensschritt E verwendete flüssige Medium das gesättigte Paraffinsulfonat, das anionische oder kationische Tensid mit perfluorierter Kohlenstoffkette, das Fettalkoholethersulfat oder Alkylphosphat in Mengen von 0,001 bis 1 Gew.%, bezogen auf die Gesamtmenge des flüssigen Mediums, enthält.

Gegenstand der vorliegenden Erfindung ist außerdem ein derartiges Verahren, wobei auch die für den Verfahrensschritt F verwendeten flüssigen Medien mindestens ein gesättigtes Paraffinsulfonat mit einer Kohlenstoffkette mit 8 bis 20 Kohlenstoffatomen oder ein anionisches oder kationisches Tensid mit einer oder mehreren 5 bis 18 Kohlenstoffatome aufweisenden perfluorierten Kohlenstoffketten, das Fettalkoholethersulfat und/oder Alkylphosphat, vorzugsweise in Mengen von 0,001 bis 1 Gew.%, bezogen auf die Gesamtmenge der jeweils flüssigen Medien, enthalten.

Es zeigt sich ferner in überraschender Weise, daß durch die Anwendung dieser ausgewählten Tenside die Standzeit der Nachbehandlungsbäder drastisch erhöht werden kann.

Die erfindungsgemäße Nachbehandlung durch die Verfahrensschritte E und F kann an photopolymerisierten Reliefdruckformen ausgeführt werden, deren Reliefschichten durch die Verfahrensschritte A und B oder A bis D hergestellt worden sind. Es ist aber durchaus möglich, daß sich der erfindungsgemäßen Nachbehandlung durch die Verfahrensschritte E und F von photopolymerisierten Reliefdruckformen, deren Reliefschichten durch die Verfahrensschritte A und B oder A bis D hergestellt worden sind, die Verfahrensschritte G und/oder H anschließen. Bevorzugt wird eine Nachbehandlung durch die Verfahrensschritte E und F von photopolymerisierten Reliefdruckformen, deren Reliefschichten durch die Verfahrensschritte A und B hergestellt worden sind. An solchermaßen hergestellten und nachbehandelten photopolymerisierten Reliefdruckformen können dann noch die Verfahrensschritte G und/oder H ausgeübt werden.

Zur erfindungsgemäßen Nachbehandlung können die zu behandelnden Reliefdruckformen in die erfindungsgemäßen Medien eingetaucht oder mit diesen Medien besprüht werden. Dem Eintauchen der zu behandelnden photopolymerisierten Reliefdruckformen in die Medien wird dabei der Vorzug gegeben.

Ein großer Vorteil der erfindungsgemäßen Nachbehandlung der Oberflächen von photopolymerisierten Reliefdruckformen für den Flexodruck ist, daß man klebfreie, glatte, strukturlose Oberflächen erhält. Ein weiterer entscheidender Vorteil des erfindungsgemäßen Verfahrens ist die lange Standzeit der angewendeten mindestens eines der oben genannten Tenside sowie elementares Brom enthaltenden oder mindestens eines der oben genannten Tenside enthaltenden und zur Bildung von elementarem Brom befähigten flüssigen Medien. Diese überraschend lange Standzeit erlaubt eine weitgehende Freiheit in der Wahl des Zeitpunktes der Herstellung der Nachbehandlungslösung und damit die Herstellung auf Vorrat.

Die Druckversuche mit den erfindungsgemäß behandelten photopolymerisierten Druckreliefs zeigen überraschenderweise eine außerordentlich hohe Standfestigkeit der Druckformen. Auch bei Auflagen bis über eine Million blieb die Oberfläche klebfrei. Dies ist unabhängig von der Art des Druckfarbenlösungsmittels und stellt einen außerordentlichen Fortschritt dar. Dadurch wird ein Reißen der Papierbahn auch bei hohen Auflagen vermieden. Im folgenden werden die Ausführung des erfindungsgemäßen Verfahrens und die für diese Ausführung vorteilhafterweise verwendeten Mittel im einzelnen beschrieben, und es werden anhand charakteristischer Beispiele die Vorteile des erfindungsgemäßen Verfahrens veranschaulicht.

Im Rahmen der vorliegenden Erfindung werden zur Nachbehandlung von zu behandelnden photopolymerisierten Reliefdruckformen für den Flexodruck flüssige Medien eingesetzt, die mindestens ein gesättigtes Paraffinsulfonat, ein anionisches oder kationisches Tensid mit perfluorierter Kohlenstoffketten, ein Fettalkoholethersulfat oder ein Alkylphosphat sowie elementares Brom enthalten oder mindestens ein derartiges Paraffinsulfonat oder ein anderes der genannten Tenside enthalten und zur Bildung von elementarem Brom befähigt sind. Unter flüssigem Medium ist dabei ein reines Lösungsmittel oder ein Gemisch aus zwei oder mehreren Lösungsmitteln zu verstehen, das gegebenenfalls noch weitere gasförmige und/oder feste gelöste Stoffe, ausgenommen Brom oder einen der oben genannten Tenside, enthalten kann. Als flüssige Medien kommen demnach in Frage üblicherweise eingesetzte aprotisch polare Lösungsmittel, wie beispielsweise Diethylether, Di-n-butylether, Tetrahydrofuran, Dioxan, Aceton, Methylethylketon, Cyclohexanon, Acetylaceton, Essigsäureethylester, Acetylessigsäureethylester, Acetonitril, Propionitril u.ä. Es kommen ferner in Frage üblicherweise eingesetzte protisch polare Lösungsmittel, wie beispielsweise Methanol, Ethanol, Propanol, n-Butanol, Essigsäure, Wasser u.ä. Es kommen weiterhin in Frage üblicherweise verwendete unpolare Lösungsmittel, wie beispielsweise Chloroform, Methylenchlorid, Perchlorethylen u.ä. Die Aufzählung dient der Illustration der Erfindung und beinhaltet keine Einschränkung. Die obengenannten Lösungsmittel können für sich alleine oder als homogene Gemische eingesetzt werden. Definitionsgemäß können diese flüssigen Medien im Sinne der Erfindung noch weitere Stoffe enthalten. Als solche kommen in Frage: Gase, wie beispielsweise Chlorwasserstoff, Bromwasserstoff, Sauerstoff u.ä. oder Feststoffe, wie beispielsweise anorganische und organische Salze. Als Basis flüssiger Medien oder als flüssige Medien selbst werden bevorzugt Perchlorethylen, n-Butanol oder Wasser eingesetzt. Ganz besonders bevorzugt wird Wasser eingesetzt.

Die erfindungsgemäßen Medien enthalten elementares Brom oder sind befähigt, elementares Brom zu bilden. Die Konzentration an freiem, elementarem Brom in den Nachbehandlungsbädern liegt vorzugsweise bei 0,2 bis 1 Gew.-%, bezogen auf die Gesamtmenge des Nachbehandlungsbades. Das elementare Brom kann dem Nachbehandlungsbad bzw. dem flüssigen Medium in Form von elementarem Brom als solchem zugesetzt werden, es kann aber auch in Form eines Gemisches aus Eisessig und elementarem Brom zugegeben werden. Es eignen sich auch bromabgebende Bromkomplexe, wie beispielsweise der Dioxan-Brom-Komplex (Dioxandibromid, vgl. Chemical Abstracts 1953, Band 47, Nr. 8032 h), Pyridinhydrobromiddibromid oder Polyvinylpyrrolidon . $HBr_3$. In solchen Fällen bezieht sich die vorstehend genannte Konzentrationsabgabe auf die Menge an abzugebendem Brom. Außer den vorstehend angegebenen Methoden gibt es aber auch die Möglichkeit, elementares Brom durch Reaktionen geeigneter Partner im flüssigen Medium selbst in situ zu erzeugen. Zu diesem Zwecke eignen sich Gemische aus einem Bromid, Bromat und einer Säure oder Gemische aus einem Bromid und Alkalimonopersulfat, so wie sie beispielsweise in der EP-PS 64 565 beschrieben werden.

Die Nachbehandlungsbäder bzw. die flüssigen Medien enthalten als erfindungswesentlichen Bestandteil ein spezielles Tensid oder mehrere spezielle Tenside. Die für das erfindungsgemäße Verfahren zur Anwendung kommenden Tenside gehören der Gruppe der gesättigten Paraffinsulfonate, die eine gesättigte Kohlenwasserstoffkette mit 8 bis 20 Kohlenstoffatomen aufweisen, der anionischen oder kationischen Tenside mit einer oder mehreren gesättigten perfluorierten Kohlenstoffketten mit 5 bis 18 Kohlenstoffatomen, der Fettalkoholethersulfate und/oder der Alkylphosphate an. Diese speziellen Tenside werden vorzugsweise in Mengen von 0,001 bis 1 Gew.-%, bezogen auf die Gesamtmenge des jeweiligen flüssigen Mediums, angewendet. Es hat sich gezeigt, und wird anhand von Vergleichsversuchen belegt, daß nur Tenside dieser Art zu dem gewünschten Verfahrenserfolg führen.

Zu den erfindungsgemäß anzuwendenden gesättigten Paraffinsulfinaten mit einer gesättigten Kohlenwasserstoffkette mit 8 bis 20 Kohlenstoffatomen bzw. anionischen oder kationischen Tensiden, die mindestens eine perfluorierte Kohlenstoffkette mit 5 bis 18 Kohlenstoffatomen enthalten, gehören beispielsweise die Alkylsulfonate und ihre Salze, wie etwa Natriumdodecyl-, -tridecyl-, -tetradecyl-, -pentadecyl-, -hexadecyl-, -heptadecyl-, -octadecyl-, -nonadecyl- und Natriumeicosanylsulfonat oder Kaliumperfluorpentyl-, -perfluorhexyl-, -perfluorheptyl-, -perfluoroctyl-, -perfluornonyl-, -perfluordecyl-, -perfluorundecyl-, -perfluordodecyl-, -perfluortridecyl-, perfluortetradecyl-, -perfluorpentadecyl-, -perfluorhexadecyl-, -perfluorheptadeyl- und Kaliumperfluoroctadecylsulfonat, sowie deren Gemische. Als Fettalkoholethersulfate kommen solche mit 12 bis 20 Kohlenstoffatomen, beispielsweise entsprechende Alkalisalze, wie etwa Natrium-3,6-dioxahexadecyl-, -3,6-dioxaheptadecyl-, -3,6-dioxaocatadecyl-, -3,6-dioxanonadecyl-, -3,6-dioxaeicosanyl-, -3,6-dioxaheneicosanyl-und Natrium-3,6-dioxadocosanylsulfat in Frage. Als Alkylphosphate kommen Fettalkoholphosphorsäuremonoester mit 8 bis 20 Kohlenstoffatomen und ihre Mono- und -Dialkalisalze, wie etwa Natrium- und Dinatriumoctyl-, -nonyl-, -decyl-, -undecyl-, -dodecyl-, -tridecyl-, -tetradecyl-, -pentadecyl-, -hexadecyl-, -heptadecyl-, -octadecyl-, -nonadecyl- sowie Natrium- und Dinatriumeicosanylphosphat in Betracht. Andere Tenside, wie z.B. ethoxilierte Fettalkohole, wie ethoxiliertes Octanol, Nonanol, Decanol, Undecanol, Dodecanol, Tridecanol, Tetradecanol, Pentadecanol, Hexadecanol, Heptadecanol, Octadecanol, Nonadecanol und Eicosanol mit 5 bis 20 Ethylenoxideinheiten, insbesondere 8 Ethylenoxideinheiten im Molekül, Dimethylalkylbenzylammoniumbromide, wie etwa Dimethyloctyl-, -nonyl-, -decyl-, -undecyl-, -dodecyl-, -tridecyl-, -tetradecyl-, -pentadecyl-, -hexadecyl-, -heptadecyl-, -octadecyl-, -nonadecyl- und Dimethyleicosanylbenzylammoniumbromid, Ethylenoxid-Propylenoxid-Blockcopolymerisate, wie EthylenoxidPropylenoxid-Zweiblockcopolymerisate, die Ethylenoxidblöcke mit 5 bis 200 Ethylenoxideinheiten und Propylenoxidblöcke mit 5 bis 200 Propylen-1,2-oder Propylen-1,3-oxid-Einheiten aufweisen, Alkylglucoside, wie Butyl-, Pentyl-, Hexyl-, Heptyl-, Octyl-, Nonyl-, Decyl-, Undecyl-, Dodecyl-, Tridecyl-, Tetradecyl-, Pentadecyl-, Hexadecyl-, Heptadecyl-, Octadecyl-, Nonadecyl-, Eicosanyl-, Heneicosanyl-, Docosanyl-, Tricosanyl-, Tetracosanyl-, Pentacosanyl-α-und -β-D-glucosid u.a. können gegebenenfalls mitverwendet werden.

Tenside der vorstehend beschriebenen Art sind allgemein bekannt und im Handel erhältlich.

Nach dem erfindungsgemäßen Verfahren erfolgt nach der Bromierung der Oberfläche der entwickelten photopolymerisierten Reliefdruckform eine weitere Nachbehandlung mit einem neutralisierend und/oder reduzierend wirkenden flüssigen Medium, welches gegebenenfalls mindestens ein im Verfahrensschritt E einzusetzendes gesättigtes Paraffinsulfonat, ein Tensid mit perfluorierter Kohlenstoffkette, ein Fettalkoholethersulfat und/oder ein Alkylphosphat enthält. Als flüssige Medien kommen hierbei die vorstehend genannten in Betracht. Vorteilhafterweise werden die gleichen Tenside wie für die Bromierungsbäder verwendet. Die neutralisierende Wirkung des flüssigen Mediums wird durch basische Zusätze eingestellt. Als basische Zusätze kommen in Frage Alkali- und Erdalkalihydroxide, Carbonate, Acetate u.ä. sowie organische und anorganische Stickstoffbasen, wie beispielsweise Ammoniak, Triethylamin u.ä. Die reduzierende Wirkung wird durch Zugabe von reduzierenden Verbindungen erhalten. Besonders bevorzugt eingesetzte Verbindungen dieser Art sind Natriumthiosulfat und Formaldehydnatriumsulfoxylat (HOCH$_2$SOONa). Diese Verbindungen haben außerdem den Vorteil, daß sie zusätzlich zu ihrer reduzierenden Wirkung auch noch basische Eigenschaften besitzen.

Die flüssigen Medien der genannten Art dienen dem Auswaschen von Bromresten auf der Oberfläche der bromierten photopolymerisierten Reliefdruckform. In erfindungsgemäß bevorzugter Verfahrensweise wird zum Auswaschen der Bromreste eine wäßrige Lösung, die 1 Gew.-% an Natriumthiosulfat oder an Formaldehydnatriumsulfoxylat (HOCH$_2$SOONa) und gegebenenfalls 0,01 bis 1 Gew.-% von mindestens einem der vorstehend genannten Tenside enthält, verwendet.

Bei Verwendung der erfindungsgemäßen flüssigen Medien, welche elementares Brom und mindestens eines der vorstehend beschriebenen Tenside enthalten oder die zur Bildung von elementarem Brom befähigt sind und mindestens eines der vorstehend beschriebenen Tenside aufweisen, benötigt man für die Nachbehandlung der Oberfläche photopolymerisierter Reliefdruckformen Tauchzeiten zwischen 1 und 15, vorzugsweise zwischen 1,5 und 10 und insbesondere zwischen 2,5 und 7 Minuten. Für das Auswaschen von Bromresten aus der Oberfläche der photopolymerisierten und bromierten Reliefdruckformen benötigt man bei Verwendung eines flüssigen Mediums, welches neben Natriumthiosulfat oder Formaldehydnatriumsulfoxylat gegebenenfalls noch ein Tensid enthält, 5 bis 60, vorzugsweise 10 bis 50 und insbesondere 15 bis 40 Sekunden.

Das erfindungsgemäße Verfahren eignet sich insbesondere für die Behandlung von solchen photopolymerisierten Reliefschichten von Flexodruckformen, die in an sich bekannter Weise durch bildmäßiges Belichten mit aktinischem Licht von photopolymerisierbaren reliefbildenden Schichten von Flexodruckplatten, enthaltend a) mindestens ein Bindemittel auf der Basis elastomerer Dienpolymerisate, b) mindestens ein damit verträgliches, olefinisch ungesättigtes, photopolymerisierbares bzw. photovernetzbares Monomeres, c) mindestens einen Photoinitiator und gegebenenfalls weitere nicht-polymerisierbare bzw. nicht-vernetzbare Hilfs- und/oder Zusatzstoffe, und anschließendes Entwikkeln der Reliefs hergestellt wurden.

Elastomere Dienpolymerisate, die als Bindemittel für die photopolymerisierbaren reliefbildenden Schichten von Flexodruckplatten in Frage kommen, sind insbesondere die entsprechenden Polymerisate von konjugierten aliphatischen Dienen mit 4 bis 5 Kohlenstoffatomen. Als Beispiele hierfür seien genannt: Naturkautschuk, die Homopolymerisate von Butadien und Isopren, Copolymerisate von Butadien und Isopren untereinander sowie die Copolymerisate von Butadien und/oder Isopren mit anderen copolymerisierbaren Monomeren, wie insbesondere Styrol, Acrylnitril, (Meth)-acrylsäurealkylestern mit 1 bis 8 Kohlenstoffatomen in der Alkylgruppe und anderen. Beispiele für solche Copolymerisate sind die Nitrilkautschuke (z.B. Butadien-Acrylnitril-Copolymerisate mit einem Acrylnitril-Gehalt von 15 bis 40 Gew.-%, so wie sie beispielsweise in der EP-A 64 564 beschrieben sind und die gegebenenfalls Carboxylgruppen enthalten); Copolymerisate aus Styrol und Butadien und/oder Isopren mit statistischer Verteilung der Monomeren und einem Gehalt an einpolymerisiertem Styrol von vorzugsweise 10 bis 50 Gew.-%; Blockcopolymerisate aus Styrolmonomeren und Butadien und/oder Isopren, so wie sie beispielsweise in der DE-AS 22 15 090, der DE-OS 24 56 439 und der DE-OS 29 42 183 beschrieben sind. Günstig als Bindemittel sind ferner Zweiblockcopolymerisate des Typs A-B und Dreiblockcopolymerisate des Typs A-B-A mit einem bzw. zwei thermoplastischen Styrolpolymerisat-Blöcken A und einem elastomeren Butadien-und/oder Isopren-Polymerisatblock B und einem Anteil an einpolymerisiertem Styrol im allgemeinen im Bereich von 10 bis 50 Gew.-% sowie elastomere Dreiblockcopolymerisate des Typs A-B-C mit einem thermoplastischen, nicht-elastomeren Styrolpolymerisat-Block A, einem elastomeren Butadien- und/oder Isopren-Polymerisat-Block B und einem von B verschiedenen elastomeren Polymerblock C aus Butadien und/oder Isopren sowie gegebenenfalls Styrol, wie sie beispielsweise gemäß der DE-OS 29 42 183 als Bindemittel verwendet werden sollen.

Bevorzugt verwendet werden die Styrol-Isopren-Dreiblockcopolymerisate, auch Flexokautschuk IV genannt, gemäß DE-OS 29 42 183 und Butadien/Acrylnitril-Copolymerisate gemäß EP-A 64 564. Ganz besonders bevorzugt verwendet wird Flexokautschuk IV. In erfindungsgemäß bevorzugter Verfahrensweise enthalten die lichtempfindlichen Mischungen die Blockcopolymerisate in Mengen von 60 bis 99 und insbesondere 70 bis 95 Gew.-%, bezogen auf die Gesamtmenge an lichtempfindlicher Mischung.

Als weiteren wesentlichen Bestandteil enthalten die photopolymerisierbaren reliefbildenden Schichten der lichtempfindlichen Flexodruckplatten mindestens ein mit dem elastomeren Diencopolymerisat verträgliches olefinisch ungesättigtes, photopolymerisierbares bzw. photovernetzbares Monomeres. Unter Verträglichkeit ist in diesem Zusammenhang die Fähigkeit zweier oder mehrerer Komponenten zu verstehen, ineinander dispergiert zu bleiben, ohne dabei Lichtstreuung hervorzurufen. Eine solche Verträglichkeit ist oft begrenzt durch Mengenverhältnisse der Komponenten, und Unverträglichkeit zeigt sich durch die Bildung von Trübungen oder Schleiern in der photopolymerisierbaren Mischung. Eine leichte Trübung solcher Mischungen kann unter Umständen noch toleriert werden, wenn aber eine detailgetreue Wiedergabe gewünscht ist, dann sollte eine solche Trübung völlig vermieden werden. Die Menge an olefinisch ungesättigten Verbindungen, welche der lichtempfindlichen Mischung zugesetzt wird, richtet sich daher in erster Linie nach der Konzentration, welche gerade noch nicht unerwünschte Lichtstreuung oder Trübung hervorruft.

Als geeignete Monomere seien besonders genannt die Ester der Acrylsäure und/oder Methacrylsäure mit ein- oder mehrwertigen Alkoholen, wie n-Butylacrylat, n-Butylmethacrylat, 2-Ethylhexylacrylat, 1,1,1-Trimethylolpropantriacrylat, Pentaerythrittetraacrylat, Diethylenglykoldiacrylat und -methacrylat, Laurylacrylat, Hydroxipropylacrylat etc. Geeignet sind auch N-Vinylverbindungen wie N-Vinylpyrrolidon, Vinylester aliphatischer Monocarbonsäuren wie Vinyloleat, Vinylether von Diolen wie Butandiol-1,4-divinylether sowie Allylether und Allylester. Gleiches gilt für die Umsetzungsprodukte von Di- oder Polyepoxiden, wie Butandiol-1,4-diglycidylether oder Bisphenol-A-diglycidylether mit (Meth)acrylsäure, soweit sie hinreichend verträglich mit dem Polymeren sind. Ein Gemisch von Acrylsäure- und Methacrylsäurederivaten ist zur Verbesserung der elastischen Werte und der Reißdehnungswerte der Reliefdruckformen sowie der Haftvermittlung bei Mehrschichtenverbundplatten besonders vorteilhaft. Allgemein können durch geeignete Wahl der Monomeren oder Mischungen von ihnen die Eigenschaften der daraus hergestellten Reliefdruckformen für den speziellen Anwendungszweck modifiziert werden. Die vorstehend genannte Aufzählung beinhaltet demnach keine Einschränkung, sondern dient der Illustration der Erfindung.

Die photopolymerisierbaren reliefbildenden Schichten der Flexodruckplatten enthalten ferner einen üblichen Photoinitiator, im allgemeinen in einer Menge von 0,01 bis 10 und insbesondere 0,01 bis 5 Gew.-%, bezogen auf die Gesamtmenge der photopolymerisierbaren reliefbildenen Schicht, wie Benzoin oder Benzoinderivate, z.B. Benzoinmethyl- oder -isopropylether oder Benzil-1,1-acetale, wie z.B. Benzil-1,1-dimethylacetal. Es kommen aber auch die als Photoinitiatoren wirksamen Acylphosphinoxide u.a. in Frage. Die Aufzählung dient der Illustration der Erfindung und beinhaltet keine Einschränkung. Es ist dem Fachmann bekannt, daß sich noch zahlreiche weitere Verbindungen als Photoinitiatoren eignen, sofern sie in einem Wellenlängenbereich von 200 bis 800 nm Licht absorbieren und dabei freie Radikale freisetzen.

Die photopolymerisierbaren reliefbildenden Schichten der Flexodruckplatten können ferner auch weitere übliche Zusätze enthalten, wie Inhibitoren der thermischen Polymerisation, wie p-Methoxiphenol, Hydrochinon und N-Nitrosoverbindungen, Farbstoffe, photochrome Substanzen, Antioxidantien sowie Weichmacher, letztere zur besseren Verarbeitbarkeit der photopolymerisierbaren reliefbildenden Schichten.

Die Stärke der photopolymerisierbaren reliefbildenen Schichten der Flexodruckplatten der oben beschriebenen Art bzw. der photopolymerisierten Reliefschichten der Flexodruckformen, die daraus entstehen, beträgt zweckmäßig 200 bis 2000 μm und insbesondere 300 bis 3000 μm. Bevorzugte Reliefdruckformen weisen nach der Photovernetzung durch Totalbelichtung mit aktinischem Licht eine Härte von 30 bis 90 und insbesondere 40 bis 70 Shore A auf. Die photopolymerisierbaren reliefbildenden Schichten der Flexodruckplatten werden besonders vorteilhaft aus ihren Lösungen in geeigneten Lösungsmitteln, wie Cyclohexan, Toluol, Xylol oder Tetrahydrofuran, durch Gießen hergestellt.

Die photopolymerisierbaren reliefbildenden Schichten der oben beschriebenen Art bzw. die photopolymerisierten Reliefschichten, die daraus hergestellt werden, können auf einem dimensionsstabilen Träger aufliegen, bzw. mit einem solchen dimensionsstabilen Träger mit Hilfe von Haftlackschichten oder beidseitig klebenden Folien haftfest verbunden sein. Als dimensionsstabile Träger kommen in Frage Kunststoff-Folien, wie z.B. Polyester-Folien sowie metallische Träger, z.B. Stahlbleche, Eisenbleche oder Aluminiumbleche.

Es ist oft von Vorteil, auf die photopolymerisierbaren reliefbildenden Schichten der Flexodruckplatten noch eine haftfest verbundene, dünne, klebfreie Überzugsschicht aufzubringen, die bevorzugt aus einem harte, klebfreie, transparente und reißfeste Filme bildenden Polymeren bestehen, z.B. einem in Entwicklerlösungsmittel löslichen Polyamid bzw.

Copolyamid, einem Polyurethan oder einem Gemisch eines solchen Polymeren mit einer geringen Menge (nicht mehr als 10 Gew.-%) eines photopolymerisierbaren Monomeren sowie eines Photoinitiators. Die Stärke dieser Überzugsschicht beträgt zweckmäßigerweise etwa 0,5 bis 20 μm. Durch eine solche Überzugsschicht ist eine Negativauflage bei der Reliefdruckform-Herstellung aus den Mehrschichtverbundplatten ohne Gefahr von Luftblaseneinschlüssen und -eindrücken problemlos möglich, wenn die bildmäßige Belichtung unter Verwendung handelsüblicher Belichtungsgeräte vorgenommen wird, bei denen mit Hilfe von leichtem Unterdruck eine Vakuumfolie das Negativ auf die zu belichtende Platte anpreßt. Es ist ferner oft vorteilhaft, die Überzugsschicht noch mit einer abziehbaren Schutzfolie wie einer Polyesterfolie zu versehen, wobei diese auch zusammen mit der Überzugsschicht auf die reliefbildende Schicht aufgebracht werden kann. Die Schutzfolie wird im allgemeinen vor der bildmäßigen Belichtung abgezogen.

Die für das erfindungsgemäße Verfahren verwendeten photopolymerisierten Reliefdruckformen für den Flexodruck lassen sich aus diesen photopolymerisierbaren Flexodruckplatten in bekannter Weise durch bildmäßiges Belichten mit aktinischem Licht und anschließendes Entfernen, insbesondere Auswaschen, der unbelichteten bzw. unvernetzten Anteile der reliefbildenden Schicht herstellen. Für die bildmäßige Belichtung, die in Form einer Flachbelichtung oder Rundbelichtung erfolgen kann, eignen sich die üblichen Lichtquellen von aktinischem Licht wie handelsübliche UV-Fluoreszenzröhrchen oder Quecksilberhochdrucklampen. Die emittierte Wellenlänge sollte bevorzugt bei 300 bis 400 nm liegen bzw. auf die Eigenabsorption des in der reliefbildenden Schicht aus einem lichtempfindlichen Gemisch enthaltenden Photoinitiators abgestimmt sein. Beispielsweise geeignete Entwicklerlösungsmittel zur Reliefentwicklung durch Auswaschen der unvernetzten Anteile der reliefbildenden Schicht sind chlorierte Kohlenwasserstoffe, wie Trichlorethan, sym.-Tetrachlorethan, Tetrachlorethylen, auch Perchlorethylen genannt, Kohlenwasserstoffe wie Hexan, Toluol oder andere organische Lösungmittel wie N-Methylpyrrolidon oder Mischungen solcher Lösungsmittel mit niederen Alkoholen zur Steuerung der Auswaschwirkung sowie wäßrige Alkalilauge oder Wasser.

Die nachstehenden Beispiele erläutern das erfinderische Verfahren. Die in den Beispielen und den Vergleichsversuchen genannten Teile und Prozente beziehen sich, soweit nicht anders angegeben, auf das Gewicht.

Zur Beurteilung des Erfolgs der Verfahrensmaßnahmen wurden folgende Methoden angewendet.

1. Test auf Klebrigkeit

Die Klebrigkeit der Oberflächen der Flexodruckformen wurden mit Hilfe des Tastsinnes bestimmt und anschließend wie folgt benotet:

Note 1, nicht klebrig; Note 2, etwas klebrig; Note 3, deutlich klebrig; Note 4, sehr klebrig.

2. Bestimmung der Struktur und Glätte der Oberfläche der Flexodruckformen

Die Güte der Oberfläche nachbehandelter, entwickelter Reliefdruckformen wurde mit Hilfe von rasterelektronenmikroskopischen Aufnahmen bestimmt und beurteilt:

Note 1, glatte, strukturlose Oberfläche ohne würmchenförmige Strukturen; Note 2, weitgehend glatte, weitgehend strukturlose Oberfläche ohne würmchenförmige Strukturen; Note 3 weitgehend glatte, weitgehend strukturlose Oberfläche mit nur wenigen würmchenförmigen Strukturen; Note 4, strukturierte Oberfläche mit zahlreichen würmchenförmigen Strukturen; Note 5, stark strukturierte Oberfläche mit dicht aneinanderliegenden würmchenförmigen Strukturen.

Die Ausbildung von Tropfenspuren, die durch das Auswaschen der Halogenreste aus nachbehandelten Flexodruckformen hervorgerufen wird, wurde visuell bestimmt.

3. Standzeit von Nachbehandlungslösungen Als Standzeit von Nachbehandlungslösungen wurde der Zeitraum definiert, nach welchem die Nachbehandlungslösungen gerade noch das gleiche Resultat liefern wie frisch angesetzte.

Für die folgenden Beispiele und Vergleichsversuche wurde Mehrschichtenverbundplatten gemäß Beispiel 3 der DE-OS 29 42 183 hergestellt. Anhand dieser Mehrschichtenverbundplatten wird das erfindungsgemäße Verfahren beispielhaft aufgezeigt. Die Verwendung dieser Mehrschichtenverbundplatten dient der Illustration der Erfindung; letztere ist nicht auf diese Platten beschränkt, sondern kann auch bei anderen Platten zur Anwendung gelangen. Die Platten wurden durch ein Negativ belichtet. Nach dem Auswaschen der unbelichteten Stellen mit Perchlorethylen-n-Butanol im Verhältnis von 4:1 wurden die entstandenen photopolymerisierten Flexodruckformen getrocknet.

Beispiel 1

Eine photopolymerisierte Flexodruckform wurde 5 Minuten lang in eine 0,4 %ige wäßrige Bromlösung, die zusätzlich 0,5 Gew.-% eines Natriumparaffinsulfonates mit einer Kettenlänge mit 12 bis 18 Kohlenstoffatomen (z.B. Emulgator K 30) enthielt, bei Raumtemperatur eingetaucht. Anschließend tauchte man die Flexodruckform in eine 1 %ige wäßrige Lösung von Natriumthiosulfat (Neutralisationsbad) und ließ die Lösung 30 Sekunden einwirken. Nach dieser Zeit wurde die Flexodruckform aus der Lösung genommen, und man ließ die Flüssigkeit abtropfen. Die Flexodruckform wurde anschließend mit einem Tuch durch Abtupfen getrocknet. Die Reliefoberfläche der nachbehandelten Flexodruckform war klebfrei (Note 1) und besuß eine gleichmäßige glatte strukturlose Oberfläche (Note 1). Die Standzeit der tensidhaltigen wäßrigen Bromlösung betrug mehr als 48 Stunden.

Vergleichsversuch 1

Es wurde wie bei Beispiel 1 verfahren, nur daß die 0,4 %ige wäßrige Bromlösung und die 1 %ige Natriumthiosulfatlösung (Neutralisationsbad) kein Natriumparaffinsulfonat enthielten. Man erhielt eine klebfreie Reliefoberfläche (Note 1) mit starker würmchenförmiger Struktur (Note 4-5) und Tropfenspuren. Die Standzeit der bromhaltigen Nachbehandlungslösung betrug mehr als 48 Stunden.

Beispiel 2

Es wurde wie in Beispiel 1 verfahren; im Brombad und im Neutralisationsad wurde jedoch ein Fettalkoholethersulfatnatriumsalz (z.B. Lutensit® AS 2230) in Mengen von jeweils 1 Gew.-% eingesetzt. Man erhielt eine klebfreie (Note 1), glatte, strukturlose (Note 1) Reliefoberfläche. Es waren keine Tropfenspuren vorhanden. Die Standzeit des bromhaltigen Nachbehandlungsbades betrug 24 Stunden.

Beispiel 3

Es wurde wie in Beispiel 1 verfahren; anstelle des Natriumparaffinsulfonates wurde jedoch im Brombad und im Neutralisationsbad ein saures Alkylphosphatnatriumsalz (z.B. Lutensit A-EP) in Mengen von jeweils 1 Gew.-% eingesetzt. Man erhielt eine weitgehend klebfreie (Note 1-2), glatte, nur schwach strukturierte (Note 2) Reliefoberfläche. Es waren keine Tropfenspuren vorhanden. Die Standzeit des Brombades betrug 24 Stunden.

Vergleichsversuch 2

Es wurde wie in Beispiel 1 verfahren. Als Tensid wurde jedoch im Brombad und im Neutralisationsbad ein Alkylphenolethoxylat in Mengen von jeweils 1 Gew.-% eingesetzt. Man erhielt eine klebrige (Note 4-5), stark strukturierte (Note 4) Reliefoberfläche. Es waren keine Tropfenspuren festzustellen. Die Standzeit des Brombades betrug weniger als 10 Stunden.

Beispiel 4

Es wurde wie in Beispiel 1 verfahren. Als Tensid wurde im Brombad und im Neutralisationsbad ein handelsübliches Perfluoralkylsulfonatkaliumsalz (z.B. Fluorad® FC 95) in Mengen von jeweils 0,1 Gew.-% verwendet. Man erhielt eine klebfreie (Note 1), glatte, strukturlose (Note 1) Reliefoberfläche. Es waren keine Tropfenspuren vorhanden. Die Standzeit des Brombades betrug mehr als 48 Stunden.

**Ansprüche**

1. Verfahren zur Herstellung von klebfreien, glatten Oberflächen von photopolymerisierten Reliefdruckformen für den Flexodruck, deren Reliefschichten hergestellt wurden durch

A) bildmäßiges Belichten mit aktinischem Licht einer lichtempfindlichen, photopolymerisierbaren und/oder photovernetzbaren reliefbildenden Schicht, enthaltend

a) mindestens ein Bindemittel auf der Basis elastomerer Dienpolymerisate,

b) mindestens ein damit verträgliches, olefinisch ungesättigtes, photopolymerisierbares und/oder photovernetzbares Monomeres,

c) mindestens einen Photoinitiator,

d) gegebenenfalls enthaltend übliche Hilfs- und/oder Zusatzstoffe,

B) Auswaschen der nicht-polymerisierten und/oder nicht-vernetzten unbelichteten Bereiche mit einem geeigneten flüssigen Medium,

C) gegebenenfalls sich daran anschließendes Trocknen und/oder

D) Nachbelichten mit aktinischem Licht der so gebildeten Reliefdruckform,

bei dem

E) die Oberfläche der photopolymerisierten Reliefdruckform mit einem mindestens ein Tensid sowie elementares Brom enthaltenden oder einem mindestens ein Tensid enthaltenden und zur Bildung von elementarem Brom befähigten flüssigen Medium nachbehandelt und anschließend,

F) die Oberfläche der photopolymerisierten Reliefdruckform mit einem neutralisierend und/oder reduzierend wirkenden flüssigen Medium ausgewaschen wird und bei dem gegebenenfalls

G) die solchermaßen nachbehandelte photopolymerisierte Reliefdruckform getrocknet und/oder

H) mit aktinischem Licht nachbelichtet wird, sofern dies noch nicht im Verfahrensschritt D geschehen ist, dadurch gekennzeichnet , daß die für den Verfahrensschritt E verwendeten flüssigen Medien mindestens ein Tensid aus der Gruppe gesättigtes Paraffinsulfonat mit einer Kohlenwasserstoffkette mit 8 bis 20 Kohlenstoffatomen, anionisches oder kationisches Tensid mit einer oder mehreren 5 bis 18 Kohlenstoffatome aufweisenden perfluorierten Kohlenstoffketten, Fettalkoholethersulfat oder Alkylphosphat enthalten.

2. Verfahren nach Anspruch 1, dadurch gekennzeichnet , daß das für den Verfahrensschritt E verwendete flüssige Medium das gesättigte Paraffinsulfonat, das anionische oder kationische Tensid mit perfluorierter Kohlenstoffkette, das Fettalkoholethersulfat oder das Alkylphosphat in Mengen von 0,001 bis 1 Gew.%, bezogen auf die Gesamtmenge des flüssigen Mediums, enthält.

3. Verfahren nach einem der vorhergehenden Ansprüche, dadurch gekennzeichnet , daß auch die für den Verfahrensschritt F verwendeten flüssigen Medien mindestens ein Tensid aus der Gruppe gesättigtes Paraffinsulfonat mit einer Kohlenstoffkette mit 8 bis 20 Kohlenstoffatomen, anionisches oder kationisches Tensid mit einer oder mehreren 5 bis 18 Kohlenstoffatome aufweisenden perfluorierten Kohlenstoffketten, Fettalkoholethersulfat oder Alkylphosphat, vorzugsweise in Mengen von 0,001 bis 1 Gew.%, bezogen auf die Gesamtmenge der jeweils flüssigen Medien, enthalten.

**Claims**

1. A process for the preparation of a non-tacky, smooth surface of a photopolymerized relief printing plate for flexographic printing, whose relief layer is prepared by

A) exposing a photosensitive photopolymerizable and/or photocrosslinkable relief-forming layer imagewise to actinic light, the said layer containing

a) one or more binders based on elastomeric diene polymers,

b) one or more olefinically unsaturated, photopolymerizable and/or photocrosslinkable monomers which are compatible with the said binders,

c) one or more photoinitiators and

d) if required, conventional assistants and/or additives,

B) washing out the non-polymerized and/or noncrosslinked, unexposed areas with a suitable liquid medium,

C) if necessary, then carrying out drying and/or

D) post-exposing the resulting relief printing plate to actinic light, in which

E) the surface of the photopolymerized relief printing plate is after-treated with a liquid medium which contains one or more surfactants and elemental bromine or contains one or more surfactants and is capable of forming elemental bromine, and thereafter,

F) the surface of the photopolymerized relief printing plate is washed out with a neutralizing and/or reducing liquid medium and, if required,

G) the photopolymerized relief printing plate after-treated in this manner is dried and/or

H) post-exposed to actinic light, unless this has been carried out in step D, wherein the liquid medium used for step E contains one or more surfactants selected from the group consisting of saturated paraffinsulfonates possessing a hydrocarbon chain of 8 to 20 carbon atoms, anionic or cationic surfactants possessing one or more perfluorinated carbon chains of 5 to 18 carbon atoms, fatty alcohol ethersulfates and all phosphates.

2. A process as claimed in claim 1, wherein the liquid medium used for step E contains the saturated Paraffinsulfonate, the anionic or cationic surfactant possessing a perfluorinated carbon chain, the fatty alcohol ethersulfate or the alkyl phosphate in amounts of from 0.001 to 1% by weight, based on the total amount of the liquid medium.

3. A process as claimed in either of the preceding claims, wherein the liquid medium used for step F, too, contains one or more surfactants selected from the group consisting of saturated paraffinsulfonates possessing a carbon chain of 8 to 20 carbon atoms, anionic or cationic surfactants possessing one or more perfluorinated carbon chains of 5 to 18 carbon atoms, fatty alcohol ether-sulfates and alkyl phosphates, preferably in amounts of from 0.001 to 1% by weight, based on the total amount of the particular liquid medium.

## Revendications

1. Procédé d'obtention de surfaces lisses et non collantes de matrices d'impression en relief photopolymerisées pour l'impression flexograsphique, dont les couches en relief ont été obtenues par

A) insolation avec de la lumière actiniaque d'une couche formant des reliefs photosensible, photopolymérisable et/ou photoréticulable, comprenant

a) au moins un liant à base de polymère diénique élastomère.

b) au moins un monomère photopolymérisable et/ou photoréticulable à insaturation éthylénique compatible avec lui, c) au moins un photoinitiateur,

d) éventuellement contenant les adjuvants et/ou additifs usuels,

B) élimination des zones non exposées non polymerisèes et/ou non réticulées par lavage avec un milieu liquide approprié,

C) éventuellement séchage ultérieur et/ou

D) post-exposition à la lumière actinique de la matrice d'impression en relief ainsi formée, procédé dans lequel

E) on traite la surface de la matrice d'impression en relief photopolymérisée avec un milieu liquide contenant au moins un agent tensio-actif ainsi que du brome élémentaire ou contenant au moins un agent tensio-actif et capable de former du brome élémentaire, et ensuite

F) on lave la surface de la matrice d'impression en relief photopolymérisée avec un milieu liquide à action neutralisante et/ou réductrice, et dans lequel éventuellement

G) on sèche la matrice d'impression en relief photopolymérisée traitèe de cette maniere et/ou

H) on expose a la lumière actinique, pour autant que ceci n'ait pas été fait à l'étape D, caractérisé en ce que les milieux liquides utilisés pour l'étape E contiennent au moins un agent tensio-actif du groupe des paraffinesulfonates saturés avant une chaîne hydrocarbonée de 8 a 20 atomes de carbone, des tensioactifs anioniques ou cationiques avec une ou plusieurs chaînes carbonées perfluorées présentant 5 à 18 atomes de carbone, des sulfates d'éthers d'alcools gras ou des phosphates d'alkyle.

2. Procédé selon la revendication 1, caractérisé en ce que le milieu liquide utilisé pour l'étape E contient le paraffinesulfonate saturé, le tensio-actif anionique ou cationique à chaînes carbonées perflorées, le sulfate d'éther d'alcool gras ou le phosphate d'alkyle à raison de 0,001% à 1% en poids, par rapport à la quantité totale du milieu liquide.

3. Procédé selon l'une ou l'autre des revendications précédentes, caractérisé en ce que les milieux liquides utilisés pour l'étape F contiennent aussi au moins un tensio-actif du groupe des paraffinesulfonates saturés ayant une chaîne hydrocarbonée de 8 à 20 atomes de carbone, des tensio-actifs anioniques ou cationiques avec une ou plusieurs chaînes carbonées perfluorées présentant 5 à 18 atomes de carbone, des sulfates d'éthers d'alcools gras ou des phosphates d'alkyle, de préférence à raison de 0,001% à 1% en poids, par rapport à la quantité totale de chaque milieu liquide.